(19) Europäisches Patentamt
European Patent Office
Office européen des brevets

(11) Publication number: 0 297 050 A2

(12) # EUROPEAN PATENT APPLICATION

(21) Application number: 88810420.5

(22) Date of filing: 20.06.88

(51) Int. Cl.4: G 03 C 1/68
G 03 F 7/10

(30) Priority: 25.06.87 GB 8714863

(43) Date of publication of application:
28.12.88 Bulletin 88/52

(84) Designated Contracting States:
BE CH DE FR GB IT LI NL

(71) Applicant: CIBA-GEIGY AG
Klybeckstrasse 141
CH-4002 Basel (CH)

(72) Inventor: Cawse, John Leslie
Old Barn Cottage Rainow
Macclesfield Cheshire SK10 5TY (GB)

Harris, Philip James
44 Oak Road Cheadle
Stockport Cheshire SK8 1EJ (GB)

Cwykla, Michael Veto
9 Huntley Road
Higher Crumpsall Manchester M8 6FJ (GB)

(54) **Photopolymerisable composition.**

(57) Polymers of the formula

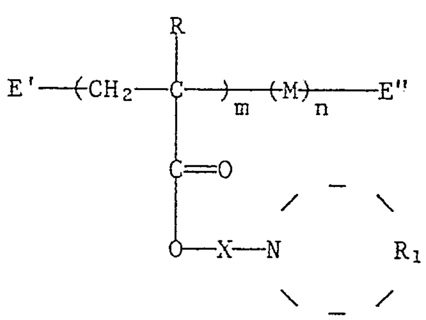

where R is hydrogen or alkyl, X is alkylene, $R_1$ represents the atoms to complete a heterocyclic ring, M is the residue of a comonomer, E′ and E″ are end-groups and m and n are the mole-fractions of monomer units, are used together with a sensitising dye as a polymerisation initiating combination.

EP 0 297 050 A2

## Description

### Photopolymerisable Composition

This invention relates to novel photopolymerisable compositions and in particular to photopolymerisable compositions which are of use in the production of volume holograms.

A large number of photopolymerisable systems are known wherein under the action of light a polymer is formed from a monomer or a mixture of monomers. Photopolymerisable materials have been used to provide raised images and in the production of photoresists.

A review of photopolymerisable processes is set forth in Chapter X of 'Imaging Systems' by Jacobson and Jacobson, John Wiley and Sons N.Y., pages 181-222 (1976). Dye-sensitized photopolymerisation is also discussed in this chapter.

In the well-known book 'Light-Sensitive Systems' by J. Kosar, John Wiley and Sons (1965) in Chapter 5 there are discussed various photopolymerisation processes. On pages 184-187 of this book there is a section on photo reducible dyes. It states on these pages that it has been well-known for many years that certain dyes will in the presence of electron donors (i.e. reducing agents) undergo reduction to their leuco form when illuminated by light. The article states that the reduced dye then reacts with ambient oxygen to produce free radicals which can initiate polymerisation of a polymerisable monomer. However it is now thought that no reaction with oxygen is required to produce free radicals.

In the patent literature triethanolamine is often quoted in the examples as a reducing agent for use in such a system. For example it is used in Examples 1 and 2 of U.S.P. 4173474.

However it has been found that in photopolymerisable systems which comprise a photo reducible dye together with a polymerisation initiating agent that the initiator is often unstable as it is a volatile compound or it is not reactive after coating and drying in a layered assembly.

It has now been found that certain polymeric compounds can be used as polymerisation initiating agents as radical sites can be formed on them by light-exposed sensitizer dyes. Such radical sites then act to initiate polymerisation. Therefore according to a first object of the present invention there is provided a photopolymerisable composition which comprises a water-soluble non-volatile ethylenically unsaturated monomer and a combination of a polymer of the formula

(1)

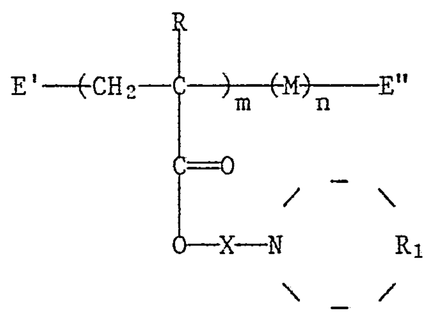

where R is hydrogen atom or a lower alkyl group having 1 to 4 carbon atoms, X is an alkylene chain having 2 to 4 carbon atoms in the chain, $R_1$ represents the atoms necessary to complete an optionally substituted 5- or 6-membered saturated nitrogen-containing ring which may contain a further heteroatom and M represents the residue of at least one ethylenically unsaturated comonomer, E′ and E″ are end-groups as defined below, m and n are mole-fractions of monomer units, with m being 0.50 to 1.00 and n being 0.50 to 0, together with a sensitising dye, which combination or exposure to light is capable of initiating free radical polymerisation of said ethylenically unsaturated monomer.

Preferably m is 0.80 to 1.00 and most preferably m is 1.00 except when comonomer M is a second tertiary nitrogen containing monomer when m and n may take any values between 0 and 1.00.

Most preferably however the polymer of formula (1) is a homopolymer. The molecular weight of the polymer can be from 5,000 to 1,000,000. If any other monomer M is present in the copolymer the units may be arranged randomly, as blocks or alternating.

Preferably R is $CH_3$ or hydrogen.

Preferably X is $(CH_2)_2$.

Preferably 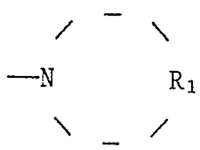 represents 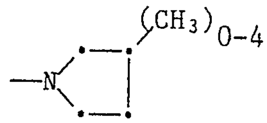

or

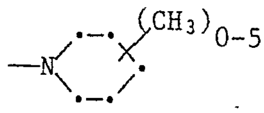

Other optional substitution in the heterocyclic ring may be other lower alkyl groups having 1 to 4 carbon atoms and lower hydroxyalkyl groups for example hydroxyethyl.

With reference to the E′ and E″ end-groups, as is well-known to anyone experienced in the art, the end-groups of polymer molecules formed by free radical initiation are generally incapable of determination with any degree of certainty, however it may be expected that at least one of the end-groups may either be an initiator residue or a group formed by disproportionation or chain transfer reactions during the preparation of the polymer of the claimed structure. Initiator residues may generally include those from alkyl or aryl peroxides, azo compounds, peroxydisulphates, peresters and peroxy carbonates, and specific examples may include the following radicals:

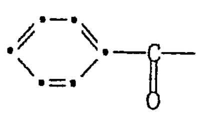 , 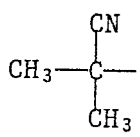 , 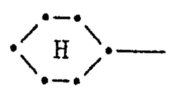 ,

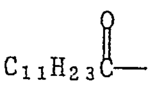 and 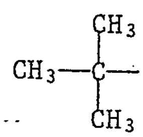 .

Further examples of commonly used initiators may be found in Polymer Handbook, Second Edition, John Wiley Publishers N.Y., 1975. Editors E.H. Immergut and J. Brandrup, Chapter II.1.

End-groups formed by disproportionation reactions may be saturated or unsaturated units from M or the initiating agent. Examples of such units may be found in Principles of Polymer Chemistry, Cornell U.P., P.J. Flay, p. 111.

It is not believed that the end-groups play any significant part in the photopolymerisation process described hereinafter.

Particularly useful polymers of formula (1) are homopolymers of formula

(2) 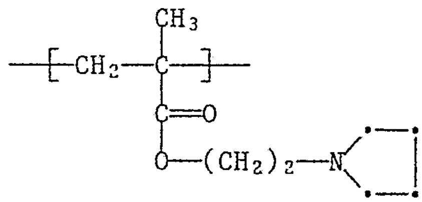 ,

of formula

(3) 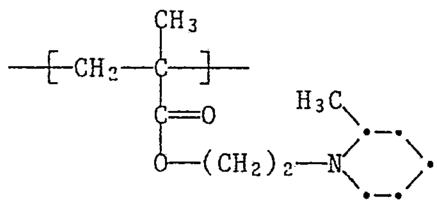 ,

of formula

(4) 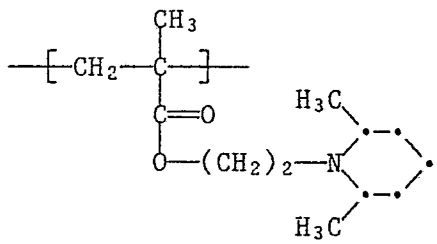

and of formula

(5) 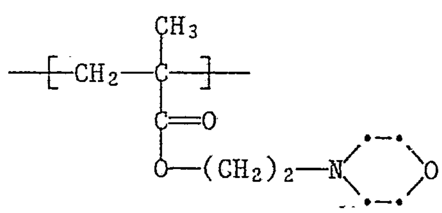 .

Copolymers which comprise at least two monomers as shown in formulae (2) to (5) may also be used.

The above monomers may be prepared by the techniques for example as listed by H. Yocum and E. Nyquist in the book "Functional Monomers", Volume 2, Marcel Dekker, New York 1974, Chapter 3, Section III B.

Suitable residues of monomers M which may be present in the polymer of formula (1) include N-vinyl pyrrolidone, acrylamide, vinylpyridine or vinyl esters.

According to a second feature of the present invention there is provided the use of a polymer of the formula (1) together with a sensitising dye as a polymerisation initiating combination.

The preferred ethylenically unsaturated monomers for use in the present invention are the metal salts of acrylic or methacrylic acids. The preferred salts are lithium, sodium, potassium, barium, lead, zinc or magnesium acrylate. The most preferred salts are lithium or zinc acrylate.

Mixtures of the metal acrylate may be used or mixtures of a metal acrylate and another ethylenically unsaturated monomer such as acrylamide, methacrylamide, N-hydroxymethylacrylamide, methylene bisacrylamide. Also esters of acrylic and methacrylic acids having low volatility may also be used, for example pentaerythritol, tetraacrylate, trimethylolpropane trimethacrylate and polybutanediol diacrylate.

The dye capable of initiating free radical polymerisation on exposure to light in the presence of the polymer of formula (1) may be any one of the dyes mentioned in the literature hereinbefore set forth. Suitable dyes include riboflavin, Rose Bengal, erythrosin and eosin. However the preferred dyes are Methylene Blue and the so-called New Methylene Blue, the latter dye being the most preferred dye.

Combination of dyes may be used and in particular Methylene Blue or New Methylene Blue together with a dye which will absorb light not absorbed by either of these dyes.

According to a third aspect of the present invention there is provided an assembly for the preparation of a hologram which comprises a transparent supporting base on which is coated a photopolymerisable composition as just defined which has been dispersed in a hydrophilic water swellable binder.

A particularly useful binder is gelatin. Other useful binders which may be used alone or preferably in admixture with gelatin are those generally used in coating procedures of photographic materials and include

albumin, casein, cellulose derivatives such as hydroxyethyl cellulose and carboxymethyl cellulose, polyvinyl alcohol, polyvinyl pyrrolidone and polyacrylamide. Preferably at least 25 % by weight of gelatin is present in the binder.

In WO 85/01127 there is described a photopolymerisable composition in which a branched polyethyleneimine serves both as the polymerisation initiator (when acted on by reduced dye) and as the binder for the composition.

However, the structure of branched polyethyleneimines is variable and difficult to determine with certainty owing to the various side-reactions which may occur during the acid catalysed polymerisation of aziridine which is the path used to prepare these compounds. Therefore it is advantageous to be able to use a polymer having a predictable structure, and the polymers of use in this invention are not only effective polymerisation initiators but also, being themselves the product of free radical polymerisation of an ethylenically unsaturated monomer, have a directly controllable composition.

Moreover, the polyethyleneimine described in WO 85/01127 is stated to be due to the ready formation of a radical site adjacent to the tertiary N atoms present in polyethyleneimine and the ability of this radical site to initiate a graft polymerisation of the ethylenically unsaturated monomer.

By using a homopolymer in which the content of tertiary nitrogen atoms is predictable and constant, as in the present invention, the variability of the polymerisation initiating agent is considerably reduced. In addition, the polymers used in the present invention are less hygroscopic than polyethyleneimine itself and therefore both the initial photosensitive coatings and the final exposed and processed holograms are less sensitive to moisture.

Other components which may be optionally present in the assembly for the preparation of a hologram are for example surfactants such as alkyl sulphates, alkylaryl sulphonates, polyalkoxylated phenols and other surfactants well-known in the literature. Inhibitors may be present to ensure dark stability of the coated compositions, examples being hydroquinone, p-methoxyphenol, or t-butyl catechol. Humectants may be present in order to allow better control over the moisture content of the coated layer during the necessary pre-exposure moisture activation step and these may include ethylene glycol, glycerol, trimethylolpropane and other polyhydroxy compounds as well as other compounds known in the art.

The supporting base may be any transparent base used in the photographic industry for example glass, biaxially oriented polyethylene terophthalate or polycarbonate or a cellulose derivative such as cellulose triacetate.

The photopolymerisable compositions of the present invention may be dispersed in an aqueous binder solution and then coated by the conventional techniques well-known to the photographic industry by doctor bar, slot, cascade, curtain and dip, and the coated layers dried by normal (hot) air methods.

The coated assemblies may be stored essentially unchanged for several months under low moisture, low temperature conditions. Before exposure the coatings are activated by bringing them into a controlled humidity environment, whereupon sufficient moisture is absorbed to enable the photopolymerisation to occur.

Exposure may be to white light or light of selected wavelengths, and the compositions of the present invention are especially suitable for exposure to lasers. The exposed assemblies may be processed by the well-known sequence of swelling in a hydrophilic bath (e.g. pure water) followed by shrinking and dehydration in a water-miscible solvent. The baths may contain, if desired, additional components, for example compounds which bring about an increase in the wavelength of the processed hologram or improved image stability. The dehydrated, exposed coatings may then be dried with warm air and laminated, if required, to produce moisture stable holographic images.

The following Examples will serve to illustrate the invention.

## Example 1

### 1. Preparation of Polypyrrolidinoethylmethacrylate (2)

Pyrrolidinoethylmethacrylate (15 g), azobis-cyanopentanoic acid (0.30 g) and ethanol (85 g) were heated under nitrogen at 60° C for 20 hours. The polymer (2) was isolated by precipitation into ice cold water, filtering and drying in vacuo. There was thus obtained 9 g (60 % conversion) of a pale yellow glass (Tg approximately 50° C), whose weight average molar mass (determined by gel permeation chromatography) was 14500.

### 2. Preparation of Photosensitive assembly using polymer (2)

A solution of lithium acrylate was first prepared by adding freshly distilled acrylic acid (1.25 g) to a cooled solution of lithium hydroxide monohydrate (0.67 g) in water (3.50 g). To this solution was added 0.003 g p-methoxyphenol as inhibitor. This solution was then mixed with 3.76 g of a 30 % weight/weight aqueous solution of polyvinyl pyrrolidone (40,000 MW) and gelatin (in equal weight proportions). Finally in the dark, the above was mixed with a solution comprising (1), 0.24 g, New Methylene Blue (3 mg in 0.5 g water) with propan-2-ol (2.7 g) as the solvent.

Within 1 hour the solution was coated under green light on to thin polyester subbed photographic base strips. The coatings had a 'wet' thickness of 100 μm. The coatings were allowed to dry for 30 minutes under a

stream of air. At this stage a supercoat of 5 % wt/wt aqueous gelatin solution was applied and again allowed to dry. Coatings were stored at 23 % RH and 19°C until required.

3. Preparation of a hologram from the above photosensitive member

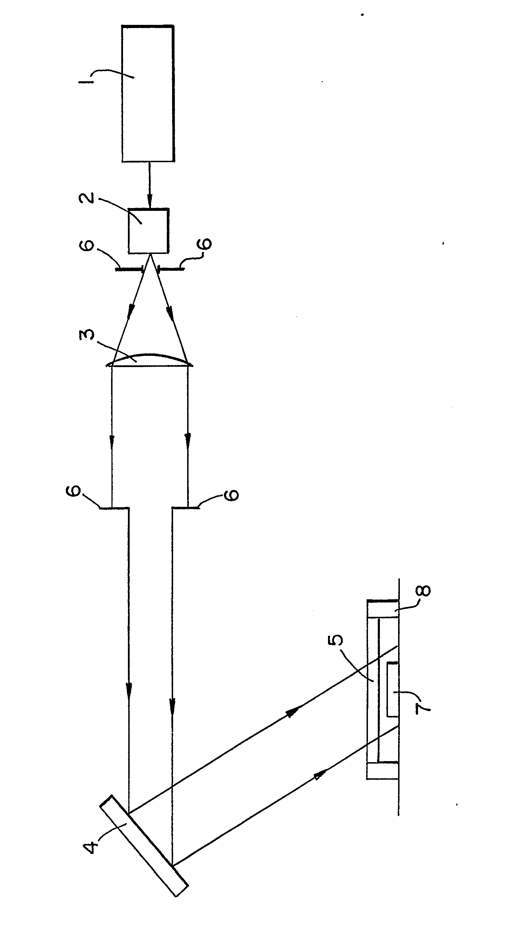

A 25 mW HeNe laser operating at 633 nm was used for holographic exposures. The assembly used is depicted in the attached figure.

In the figure the numbers designate as follows:

1. 25 mW HeNe laser
2. x 10 microscope objective (25 μm pinhole)
3. Plano-convex lens (focal length 300 mm)
4. Surface silvered mirror
5. Photosensitive member
6. Spatial filters
7. Object
8. Vibration isolated table.

A Denisyuk mode was employed for exposure, with the object 7 (a polished metal disc) approximately 1 mm beneath the photosensitive member 5.

Coated assemblies were first placed in a humidifying atmosphere at 65 % RH for 1 hour prior to exposure. Laser Exposure of 60 and 300 seconds were given.

The exposed coatings were processed at 20°C by placing them in water for 15 seconds followed by propan-2-ol for 30 seconds, then dried in a stream of cold air followed by a stream of warm air for 1 minute.

Bright, green holograms were produced. For example, a hologram prepared at 300 seconds exposure gave a holographic component reflecting 11 % of incident light at peak value of 580 nm. The bandwidth at half peak height was from 510 to 650 nm. At 60 seconds exposure the haze levels were somewhat greater, but still acceptable hologram was obtained than at 300 seconds exposure. Supercoated assemblies gave fainter images. The processed holograms were laminated with an optically clear self adhesive polyester film. The laminated holograms exhibited no change in replay wavelength or brightness over a six month storage period.

When polymers (4) and (5) were used in a photopolymerisation reaction mixture similar to that just prepared and the photopolymerisation mixtures were holographically exposed and processed as just set forth bright green holograms were also obtained.

Example 2

Preparation of poly (2-methylpiperidinoethyl methacrylate) (3)

2-methylpiperidinoethyl methacrylate (11.5 g), azobiscyanopentanoic acid (0.25 g) and ethanol (50 $cm^3$), were heated under nitrogen for 18 hours at 70°C. The polymer (3) was isolated by precipitation into water, filtering and drying in vacuo. There was thus obtained 8.7 g (75.6 %) of polymer (3), which had weight-average molar mass (determined by gel permeation chromatography) of 69,000.

Preparation of photosensitive assembly from polymer (3)

A photosensitive assembly was prepared in an analogous manner to example 1, except polymer (1) was replaced by polymer (3).

A sample of the coated assembly was humidified to 65 % RH for 35 minutes, and then located at a distance of 20 cm from at 75 W tungsten lamp. One half of the coating was masked, and thus not exposed to the light. A thermocouple was placed in contact with uncoated base.

The coating was then exposed through the base, and the heat evolved during the exothermic and rate of exothermic reaction recorded. This was used as a measure of the photo initiation efficiency. The temperature rose at a rate of 0.8°C per second. The exotherm maximum of 12°C coincided with bleaching of the sensitizer dye. Upon washing with water, and then propan-2-ol and drying, the exposed half showed increased thickness, toughness and was less tacky than the unexposed area.

On humidifying the coated assemblies to a range of relative humidities, the following exotherms and bleaching times were observed on exposure:

| RH % | Maximum exotherm °C | Bleaching time [sec] |
|---|---|---|
| 35 | 2 | 20 |
| 45 | 5.5 | 20 |
| 50 | 9.5 | 13 |
| 65 | 12.0 | 15 |
| 75 | 9.0 | 17 |

It can be seen that the optimum RH for this system is around 65 %.

Thus as can be seen a very rapid reacting photopolymerisation composition was obtained.

When the assembly of this example was holographically exposed as in Example 1 a bright hologram was obtained on replay.

Similar results were obtained when photosensitive assemblies are prepared from polymers (4) and (5).

## Claims

1. A photopolymerisable composition which comprises a water-soluble non-volatile ethylenically unsaturated monomer and a combination of a polymer of the formula

(1) 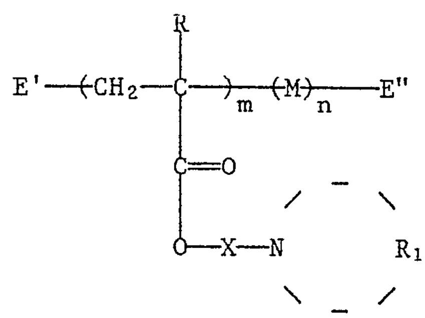

where R is a hydrogen atom or a lower alkyl group having 1 to 4 carbon atoms, X is an alkylene chain having 2 to 4 carbon atoms in the chain, $R_1$ represents the atoms necessary to complete an optionally substituted 5- or 6-membered saturated nitrogen-containing ring which may contain a further heteroatom and M represents the residue of at least one ethylenically unsaturated comonomer, E′ and E″ are end-groups, m and n are mole-fractions of monomer units, with m being 0.50 to 1.00 and n being 0.50 to 0, together with a sensitising dye, which combination on exposure to light is capable of initiating free radical polymerisation of said ethylenically unsaturated monomer.

2. A photopolymerisable composition according to claim 1 wherein the polymer of formula (1) is a homopolymer.

3. A photopolymerisable composition according to claim 1 wherein the polymer of formula (1) is a homopolymer of formula

(2) 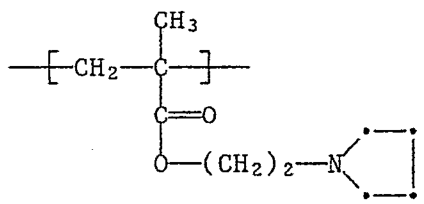 ,

of formula

(3) 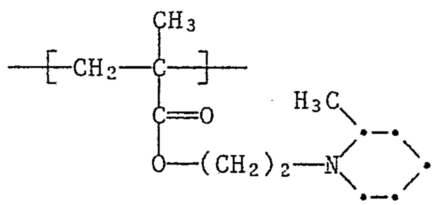 ,

of formula

(4) 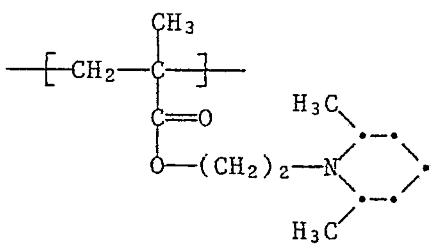

or of formula

(5) 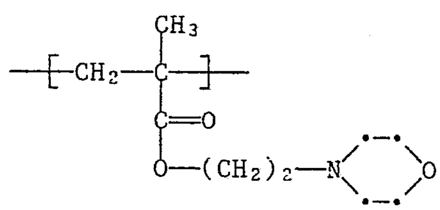 .

4. A photopolymerisable composition according to claim 1 wherein the ethylenically unsaturated monomer is a metal salt of acrylic or methacrylic acid.

5. A photopolymerisable composition according to claim 4 wherein the ethylenically unsaturated monomer is lithium or zinc acrylate.

6. A photopolymerisable composition according to claim 1 wherein the dye capable of initiating free radical polymerisation in the presence of the polymer is riboflavin, Rose Bengal, eosin, erythrosin, Methylene Blue or New Methylene Blue.

7. The use of a polymer of the general formula

(1) 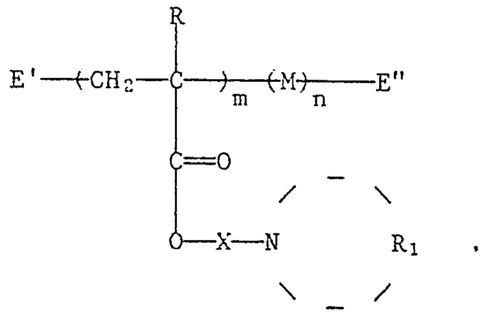

where R is a hydrogen atom or a lower alkyl group having 1 to 4 carbon atoms, X is an alkylene chain having 2 to 4 carbon atoms in the chain, $R_1$ represents the atoms necessary to complete an optionally substituted 5- or 6-membered saturated nitrogen-containing ring which may contain a further heteroatom and M represents the residue of at least one ethylenically unsaturated comonomer, E′ and E″ are end-groups, m and n are mole-fractions of monomer units, with m being 0.50 to 1.00 and n being 0.50 to 0, together with a sensitising dye as a polymerisation initiating combination.

8. The use of a polymer of formula (1) as defined in claim 7 which is a homopolymer.

9. The use of a polymer of formula (1) as defined in claim 7 wherein R is $-CH_3$ or hydrogen.

10. The use of a polymer of formula (1) as defined in claim 7 wherein X is $-(CH_2)_2$.

11. The use of a polymer of formula (1) as defined in claim 7 wherein

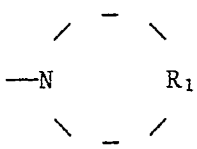 represents a radical of the formula 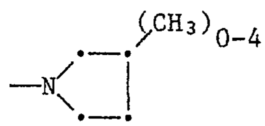

or

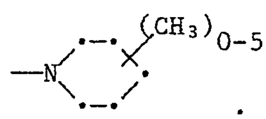 .

12. The use according to claim 7 wherein the homopolymer is of formula

(2) 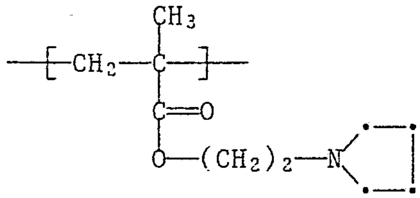 ,

of formula

(3) 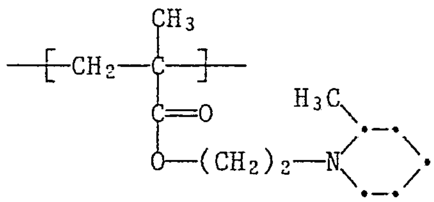 ,

of formula

(4) 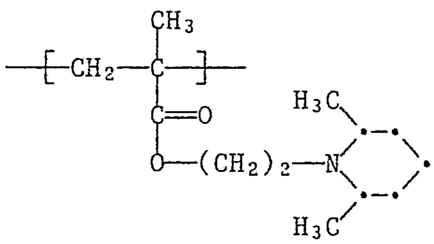

and of formula

(5) 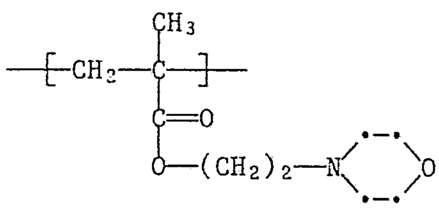 .

13. An assembly for the preparation of a hologram which comprises a transparent supporting base on which is coated a polymerisable composition as claimed in claim 1 which has been dispersed in a hydrophilic water-swellable binder.

14. An assembly according to claim 13 wherein the hydrophilic water-swellable binder is gelatin or a binder which comprises at least 25 % by weight of gelatin.

15. A process for the preparation of a hologram which comprises holographically exposing and processing an assembly as claimed in claim 13.

0297050